# EUROPEAN PATENT APPLICATION

(11) **EP 2 600 400 A1**
(43) Date of publication of application: **05.06.2013**
(21) Application number: 11812611.9
(22) Date of filing: 29.07.2011
(51) Int. Cl.: H01L 27/12, H01L 21/02, H01L 21/762

(54) **COMPOSITE SUBSTRATE, ELECTRONIC COMPONENT, METHOD FOR PRODUCING COMPOSITE SUBSTRATE, AND METHOD FOR MANUFACTURING ELECTRONIC COMPONENT**

(30) Priority: 30.07.2010 JP 2010172021
(71) Applicant: Kyocera Corporation, Kyoto-shi Kyoto 612-8501 (JP)
(72) Inventor: KITADA, Masanobu, Kyoto-shi Kyoto 612-8501 (JP)
(74) Representative: Müller - Hoffmann & Partner
(86) International application number: PCT/JP2011/067385
(87) International publication number: WO 2012/015022

(57) **Abstract**

Provided are a composite substrate which includes a silicon substrate having improved crystallinity, and a method for manufacturing a composite substrate, and a method for manufacturing an electronic component. A composite substrate (1) is formed by bonding a semiconductor substrate (20) onto a support substrate (10) having electric insulating properties. The semiconductor substrate (20) is formed of silicon. The semiconductor substrate (20) includes a plurality of first regions (20x) on each of which an element portion which functions as a semiconductor device is formed, and a second region (20y) which is positioned between the plurality of first regions (20x). In the semiconductor substrate (20), an oxidized portion (22) which is composed of silicon oxide is formed on a bottom surface (20b) of the second region (20y).

## Description

### Technical Field

The present invention relates to a composite substrate and an electronic component which are used in a semiconductor device, and a method for manufacturing the composite substrate and a method for manufacturing the electronic component.

### Background Art

Recently, a technology which decreases parasitic capacitance for improving the performance of a semiconductor device has advanced. As the technology which decreases the parasitic capacitance, there is an SOS (Silicon On Sapphire) structure. For example, as a method for forming the SOS structure, there is a technology which is disclosed in Patent Literature 1.

### Citation List

### Patent Literature

Patent Literature 1: Japanese Unexamined Patent Publication JP-A 10-12547(1998)

### Summary of Invention

### Technical Problem

However, in the technology disclosed in Patent Literature 1, since lattice structures of silicon and sapphire are different from each other, lattice defects occur in the silicon.

The invention is made in consideration of the above-described circumferences, and an object thereof is to provide a composite substrate and an electronic component which include a silicon substrate having improved crystallinity, and a method for manufacturing the composite substrate, and a method for manufacturing the electronic component.

### Solution to Problem

A composite substrate according to an embodiment of the invention includes a support substrate having electric insulating properties and a silicon substrate disposed on the support substrate. The silicon substrate includes a plurality of first regions, and a second region positioned between the plurality of first regions. Moreover, an oxidized portion contains silicon oxide as a main component, the oxidized portion being disposed on a main surface of the second region closer to the support substrate side.

A method for manufacturing a composite substrate according to an embodiment of the invention includes an oxidized portion forming step and a bonding step. In the oxidized portion forming step, in a silicon substrate including a plurality of first regions, and a second region positioned between the plurality of first regions, an oxidized portion containing silicon oxide as a main component is provided on a surface of the second region. In the bonding step, the oxidized portion of the silicon substrate is bonded to a support substrate having electric insulating properties.

A method for manufacturing an electronic component according to an embodiment of the invention includes: a step of forming an element portion which functions as a semiconductor device, on the first region in the composite substrate of the invention; and a step of dividing the composite substrate into regions each of which includes at least one element portion.

An electronic component according to an embodiment of the invention includes a support chip having electric insulating properties and a silicon chip disposed on the support chip. Moreover, the silicon chip includes a first region on which an element portion which functions as a semiconductor device is formed, and a second region which is disposed surrounding the first region. An oxidized portion contains silicon oxide as a main component which is disposed on a main surface of the second region closer to the support chip side.

### Advantageous Effects of Invention

According to the invention, a composite substrate and an electronic component which include a silicon substrate having improved crystallinity, a method for manufacturing the composite substrate, and a method for manufacturing the electronic component can be provided.

### Brief Description of Drawings

Fig. 1(a) is a plan view showing a schematic configuration of an embodiment of a composite substrate according to the invention, and Fig. 1(b) is a cross-sectional view taken along the line Ib-Ib shown in Fig. 1(a);
Fig. 2(a) to Fig.2(c) are schematic views showing an embodiment of manufacturing steps of the composite substrate according to the invention;
Fig. 3 is a schematic view showing the steps continuous to Fig. 2;
Fig. 4(a) and Fig. 4(b) are schematic views showing an embodiment of a method for manufacturing an electronic component according to the invention;
Fig. 5(a) is a plan view showing a schematic configuration of a modified example of the composite substrate shown in Fig. 1, and Fig. 5(b) is a cross-sectional view taken along the line Vb-Vb shown in Fig. 5(a);
Fig. 6(a) is a plan view showing a schematic configuration of a modified example of the composite substrate shown in Fig. 1, and Fig. 6(b) is a cross-sectional view taken along the line VIb-VIb shown in Fig. 6(a);
Fig. 7(a) is a plan view showing a schematic configuration of a modified example of the composite substrate shown in Fig. 1, and Fig. 7(b) is a cross-sectional view taken along the line VIIb-VIIb shown in Fig. 7(a);
Fig. 8(a) and Fig. 8(b) are schematic views showing modified examples of the manufacturing steps of the composite substrates shown in Figs. 2 and 3, respectively;
Fig. 9 is a cross-sectional view showing a schematic configuration of an embodiment of an electronic component according to invention;
Fig. 10 is a cross-sectional view showing a modified example of the electronic component shown in Fig. 9;
Fig. 11(a) is a plan view showing a schematic configuration of a modified example of the composite substrate shown in Fig. 1, and Fig. 11(b) is a cross-sectional view taken along the line VIIIb-VIIIb shown in Fig. 11(a);
Fig. 12(a) is a plan view showing a schematic configuration of a modified example of the composite substrate shown in Fig. 1, and Fig. 12(b) is a cross-sectional view taken along the line IXb-IXb shown in Fig.12(a);
Fig. 13(a) is a plan view showing a schematic configuration of a modified example of the composite substrate shown in Fig. 1, and Fig. 13(b) is a cross-sectional view taken along the line Xb-Xb shown in Fig. 13(a);
Fig. 14(a) is a cross-sectional view showing a schematic configuration of a modified example of the composite substrate shown in Fig. 1, and Fig. 14(b) is a cross-sectional view showing a schematic configuration of a modified example of the electronic component shown in Fig. 9; and
Fig. 15(a) and Fig. 15(b) are plan views showing modified examples of the electronic components shown in Fig. 9.

### Description of Embodiments

### <First Embodiment of Composite Substrate>

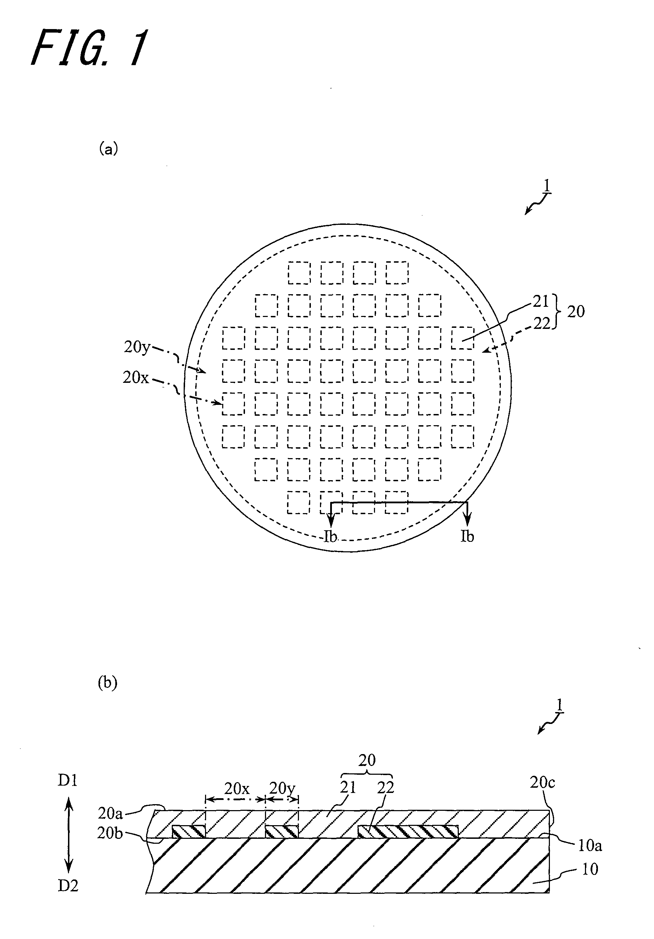

A composite substrate 1 which is an example of an embodiment of a composite substrate of the invention will be described with reference to drawings. The composite substrate 1 shown in Fig. 1 includes a support substrate 10 and a semiconductor substrate (silicon substrate) 20.

The support substrate 10 becomes a support member of the semiconductor substrate 20. In the present embodiment, the support substrate is formed of a single crystal which contains aluminum oxide as a main component (hereinafter, referred to as a "sapphire"). The semiconductor substrate 20 is supported on a main surface on a D1 direction side (hereinafter, referred to as a "top surface 10a") of the support substrate 10 and is bonded thereto.

The semiconductor substrate 20 forms , in part of itself, an element portion which functions as a semiconductor device. In the semiconductor substrate 20, a region which forms the element portion is referred to as a first region 20x, and a region which is positioned between the first regions 20x is referred to as a second region 20y. The first regions 20x are arranged in matrix on a main surface which is positioned in a D1-D2 direction of the semiconductor substrate 20 (hereinafter, referred to as a "top main surface 20a"). Note that the shape and the arrangement of the first region 20x are not limited to this, and are appropriately selected. In addition, among the second regions 20y, a portion which is positioned between the first regions 20x extends in a grid pattern on the main surface 20a. Moreover, the shape of the second region 20y is appropriately selected according to the shape and the arrangement of the first region 20x.

The semiconductor substrate 20 includes a main portion 21 and an oxidized portion 22. The main portion 21 is a portion which becomes the main portion of the semiconductor substrate 20, and is formed of a silicon single crystal (hereinafter, simply referred to as a "silicon"). The main portion 21 is mainly positioned on the first regions 20x. The oxidized portion 22 is a portion formed by oxidizing the main portion 21, and is formed of silicon oxide. The oxidized portion 22 is mainly positioned on the second regions 20y. That is, the oxidized portion 22 is formed between the first regions 20x. The oxidized portion 22 faces a main surface on a D2 direction side (hereinafter, referred to as a "bottom main surface 20b") of the semiconductor substrate 20.

Since adhesive strength between sapphire and silicon oxide is larger than adhesive strength between sapphire and silicon, the oxidized portion 22 faces the bottom main surface 20b of the semiconductor substrate 20, and thus, the adhesive strength of the bonding between the support substrate 10 and the semiconductor substrate 20 can be increased. In other words, the bonding strength between the second regions 20y and the support substrate 10 is higher than the bonding strength between the first regions 20x and the support substrate 10. That is, the bonding strength is locally different in the composite substrate 1.

In addition, since the oxidized portion 22 is positioned on the second regions 20y positioned between the first regions 20x on which the element portion is formed, electric insulating properties between the element portions, that is, isolation can be increased. Particularly, this is appropriate when a plurality of element portions form a single electronic component.

Moreover, thermal conductivity of the silicon is approximately 148 W·m⁻¹·K⁻¹, and thermal conductivity of the silicon oxide is approximately 8 W·m⁻¹·K⁻¹. That is, the thermal conductivity of the silicon is larger than the thermal conductivity of the silicon oxide. Thereby, the oxidized portion 22 is positioned on the second regions 20y which are positioned between the first regions 20x on which the element portions are formed, and thus, heat can be favorably transmitted from the first regions 20x to the support substrate 10.

Moreover, the oxidized portion 22 is formed surrounding the circumferences of the first regions 20x. In this composite substrate 1, even after the composite substrate 1 is divided into the electronic components, the support substrate 10 and the semiconductor substrate 20 can be favorably adhered. In addition, the configuration of the present embodiment can be represented in other ways in that each of the first regions 20x is separated by the oxidized portion 22. When the configuration of the present embodiment is represented in still other words, in the semiconductor substrate 20, a portion which does not overlap with the region in which the oxidized portion 22 is positioned in a plan view can be referred to as the first region 20x, and an overlapping region can be referred to as the second region 20y.

Moreover, the oxidized portion 22 is formed inside the other surfaces excluding the bottom main surface 20b of the semiconductor substrate 20, that is, inside the top main surface 20a and a side surface 20c. In other words, the main portion 21 faces the top main surface 20a and the side surface 20c of the semiconductor substrate 20. That is, the compositions of the exposed portions of the semiconductor substrate 20 are the same. Thereby, in the semiconductor substrate 20, it's enable to select and use the effective process from various processes which include a process using a composition difference between the silicon and the silicon oxide.

It is preferable that the surface roughness of the surface to be bonded of the support substrate 10 and the semiconductor substrate 20 is small, and it is more preferable that the average surface roughness Ra is less than 10 nm. Due to the fact that the average surface roughness Ra is decreased, the applied pressure when the support substrate and the semiconductor substrate are bonded to each other can be decreased. Particularly, it is preferable that the average surface roughness Ra is 1 nm or less, and in this case, the bonding can be performed by a significantly small pressure.

Next, a detail configuration of each element will be described.

The support substrate 10 is not particularly limited as long as it is a material which has electric insulating properties, and the support substrate which contains aluminum oxide, silicon carbide, or the like as a main component can be used. For example, the support substrate may include impurities while containing aluminum oxide as a main component.

The thickness of the support substrate 10 is not particularly limited as long as it is capable of supporting the semiconductor substrate 20 which is disposed on the support substrate, and for example, the support substrate which has a thickness of 600 µm to 650 µm can used.

The semiconductor substrate 20 is a silicon single crystal substrate. As for the kind of silicon, p-type silicon, n-type silicon, or non-doped silicon can be adopted. Here, the "non-doped" silicon refers to the silicon which is not doped with an intention only with respect to impurities, and is not limited to intrinsic silicon in which impurities are not included at all. A dopant concentration of the semiconductor substrate 20 may be appropriately set according to desired characteristics of the element portion which is the semiconductor device formed on the first regions 20x. When p-type impurities are doped, for example, the dopant concentration may be in a range of less than 1 x 10¹⁶ atoms/cm³. When n-type impurities are doped, the dopant concentration may be in a range of less than 5 x 10¹⁵ atoms/cm³. Moreover, the dopant concentration may be not uniform, and for example, may include a concentration distribution in the thickness direction.

Moreover, for example, the thickness of the semiconductor substrate 20 may be in a range of 50 to 10000 nm.

The element portion which functions as a semiconductor device later on is formed on the first regions 20x. Thereby, the dimension of the first region 20x in a plan view is appropriately set in order to obtain a desired element portion. For example, the width of the first region in the left and right directions of Fig. 1(a) may be 30 to 5,000 µm and the width of the first region in the up and down directions of Fig. 1(a) may be 30 to 5000 µm.

The width of the second region 20y in a plan view (the width in the left and right directions of Fig. 1(a), in other words, the width in the left and right directions of Fig. 1(b)) may be 5 to 100 µm. In other words, this width may be intervals between the plurality of adjacent first regions 20x.

The dimension of the oxidized portion 22 in a plan view may be the same as that of the second region 20y. In addition, for example, the thickness of the oxidized portion 22 may be smaller than the thickness of the semiconductor substrate 20. However, in order to increase the bonding strength thereof with the support substrate 1, the oxidized portion 22 needs the thickness which at least exceeds a natural oxidized layer. Specifically, the thickness of the oxidized portion is required to be increased so as to be at least larger than the thickness of two atomic layers. When the thickness of the semiconductor substrate 20 exceeds 200 nm, preferably, the thickness of the oxidized portion 22 may be approximately 200 nm.

### <Methods for Manufacturing Composite Substrate and Electronic Component>

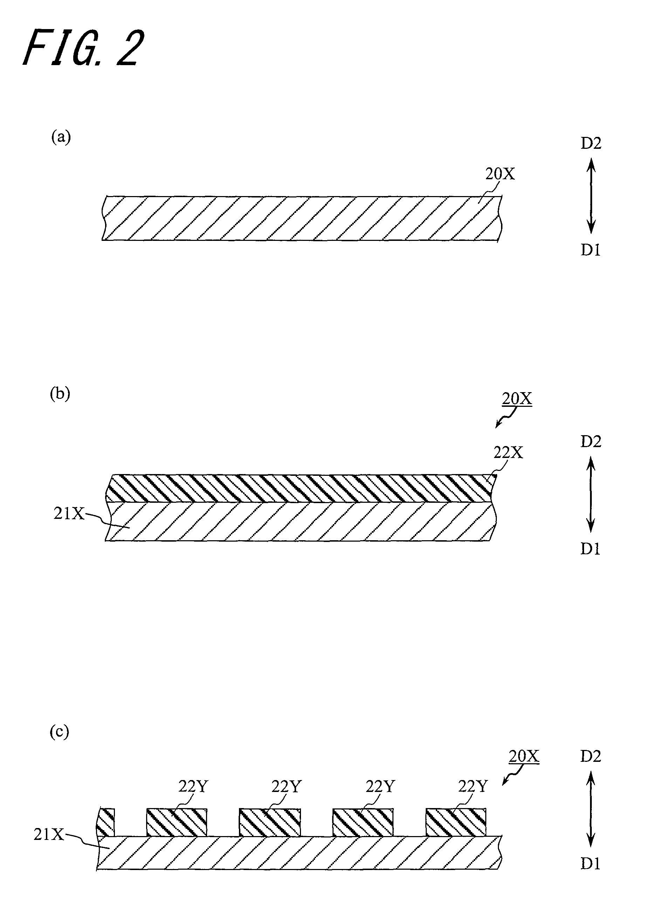

An example of embodiments of methods for manufacturing the composite substrate and the electronic component of the invention will be described with reference to Figs. 2 to 4.

### (Oxidized portion Forming Step)

First, as shown in Fig. 2(a), a substrate material 20X which becomes the semiconductor substrate 20 is prepared. In the present embodiment, silicon is adopted as the substrate material 20X.

Subsequently, as shown in Fig. 2(b), one main surface which becomes the bottom main surface 20b of the semiconductor substrate 20 among the main surfaces of the substrate material 20X is oxidized, and thus, an oxidized layer 22X is formed. In the present embodiment, as a result of the oxidation, the oxidized layer 22X which is composed of SiO₂ is formed on the entire surface of the main surface. As the oxidation treatment, various methods such as thermal oxidation and solution oxidation are adopted. Note that a region in which oxidation is not performed in the substrate material 20X is referred to as an unoxidized portion 21X.

Subsequently, as shown in Fig. 2(c), the unoxidized portion 21X is exposed by removing the portion of the formed oxidized layer 22X. The removing is performed according to the regions which become the second regions 20y. That is, the unoxidized portion 21X is exposed on the regions which become the second regions 20y. At the time of the removing, the remaining oxidized layer 22X becomes a partial oxidized layer (first oxidized layer) 22Y. As the removing method, a method which chemically etches or a method which physically etches using ion beams or the like, the surface exposed from a mask using the mask is adopted. Moreover, there is a metal mask, a photomask, or the like as the mask, and the mask is appropriately selected according to the etching method.

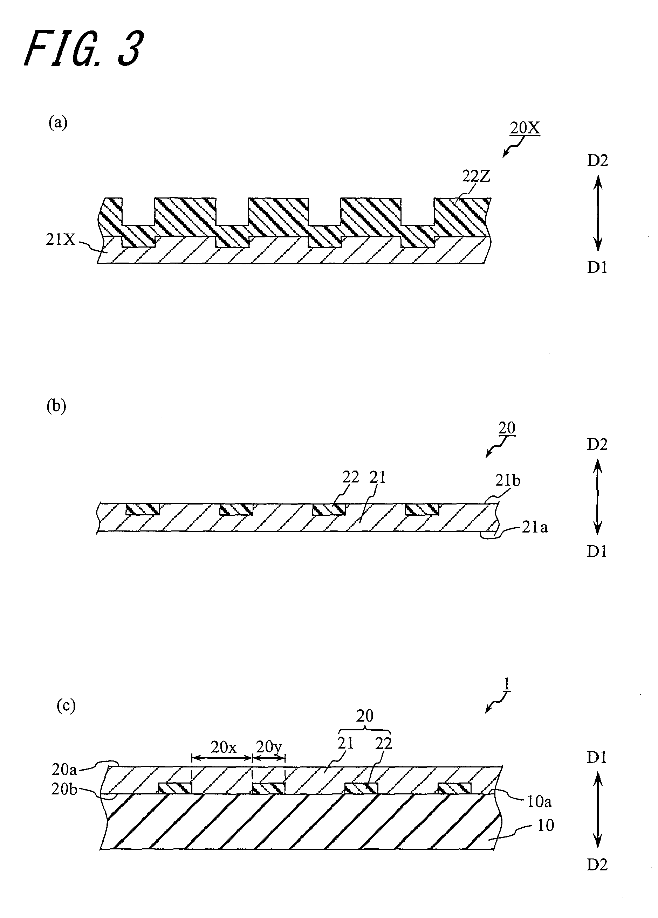

Subsequently, as shown in Fig. 3(a), the unoxidized portion 21X of the substrate material 20X is oxidized again, and thus, an oxidized layer (second oxidized portion) 22Z is formed. At the time of this oxidation treatment, the difference of the thickness between the region in which the partially oxidized layer 22Y remains and the region which is newly oxidized is controlled so as to be larger than the thickness of the oxidized portion 22. It is preferable that the thickness difference is close to the thickness of the oxidized portion 22. This control can be performed in nanometers unit using various known parameters such as the applied temperature, the concentration of oxygen, or concentration of the solution.

Subsequently, as shown in Fig. 3(b), a semiconductor substrate 20 is manufactured by finely etching the oxidized layer 22Z of the substrate material 20X. According to the fine etching, the unoxidized portion 21X is exposed from the lower portion of the region in which the partial oxidized layer 22Y previously remains, and the surface which includes the exposed unoxidized portion 21X is flattened. The unoxidized portion 21X and a portion of the oxidized layer 22Z is exposed from the flattened surface. At the time of the fine etching, the remaining oxidized layer 22Z becomes the oxidized portion 22 of the semiconductor substrate 20 and the unoxidized portion 21X after the fine etching becomes a main portion 21.

For example, as the etching means which is used in the fine etching, there is dry etching. Dry etching includes etching using a chemical reaction and etching using physical collision. As for the etching using a chemical reaction, there is etching using reactive vapor (gas), ions and ion beams, a radical, or the like. As for the etching gas which is used as the reactive ion, there is sulfur hexafluoride (SF₆), carbon tetrafluoride (CF₄), or the like. In addition, as for the etching by physical collision, there is etching using ion beams. As for the etching using ion beams, there is a method which uses a Gas Cluster Ion Beam (GCIB). It is possible to favorably perform the fine etching even with respect to a material substrate having a large area by scanning the substrate material 20X using a movable stage while etching the narrow region using the etching means.

### (Bonding Step)

Subsequently, as shown in Fig. 3(c), the support substrate 10 and the semiconductor substrate 20 are bonded to each other via the oxidized portion 22. As for the bonding method, there is a method which performs the bonding by activating the surfaces to be bonded and a method which performs the bonding using an electrostatic force. For example, as for the method which activates the surface, there is a method which performs activation by radiating ion beams in a vacuum and etching the surface, a method which activates the surface by etching the surface in a chemical solution, or the like. It is preferable that the bonding is performed at a room temperature. Moreover, the support substrate 10 and the semiconductor substrate 20 are disposed to face each other, and may be bonded by heating and pressurizing them.

In addition, at the time of the bonding, a method which does not use an adhesive such as a resin is adopted, and the support substrate 10 and the semiconductor substrate 20 are directly bonded to each other due to solid state bonding which uses an atomic force, or the like. At the time of the direct bonding, a hybrid layer may be formed between the support substrate 10 and the semiconductor substrate 20.

In this way, the composite substrate 1 is obtained. Thereafter, the semiconductor substrate 20 of the composite substrate 1 may be thinly processed so as to have a predetermined thickness. As a method for performing thin processing, various methods such as abrasive polishing, chemical etching, or ion beam etching may be adopted, and a plurality of methods may be combined. A so-called smart cut method may be used.

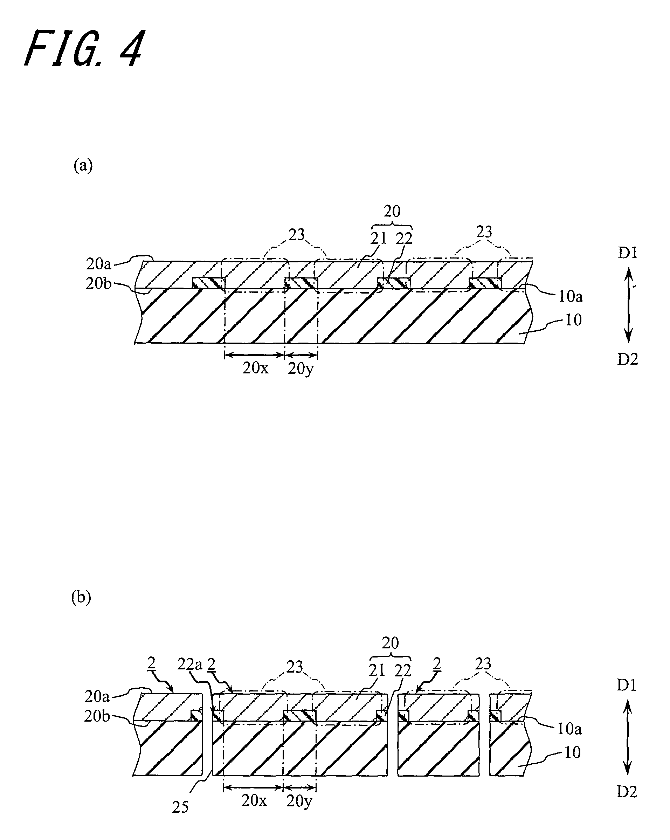

Subsequently, as shown in Fig. 4(a), element portions 23 are formed from the top main surface 20a side of the obtained composite substrate 1. The element portions 23 are formed on arbitrary first regions 20x. As the element portions 23, there are various semiconductor device structures.

Subsequently, as shown in Fig. 4(b), the composite substrate 1 on which the element portions 23 are formed is divided, and thus, electronic components 2 are manufactured. When the composite substrate 1 is divided into electronic components 2, at least one element portion 23 is included in one electronic component 2. In other words, the plurality of first regions 20x, and further, the plurality of element portions 23 may be included in one electronic component 2. Moreover, one electronic component 2 includes at least one of the oxidized portion 22 and a divided oxidized portion 22a obtained by dividing the oxidized portion 22. Since the oxidized portion 22 or the divided oxidized portion 22a is included in one electronic component 2, even at the time of using the electronic component 2, it is possible to favorably make the support substrate 10 and the semiconductor substrate 20 adhere to each other.

Moreover, as shown in Fig. 4(b), since the composite substrate 1 is divided, a divided surface 25 is newly formed. It is preferable that the composite substrate 1 is divided so as to expose the second region 20y on the divided surface 25. In other words, it is preferable that the composite substrate 1 is divided so as to expose the oxidized portion 22 or the divided oxidized portion 22a on the divided surface 25. According to this division, even at the time of using the electronic component 2, it is possible to suppress the semiconductor substrate 20 from being peeled off from the circumference.

In this way, the electronic component 2 which includes the element portion 23 can be manufactured.

### <Second Embodiment of Composite Substrate>

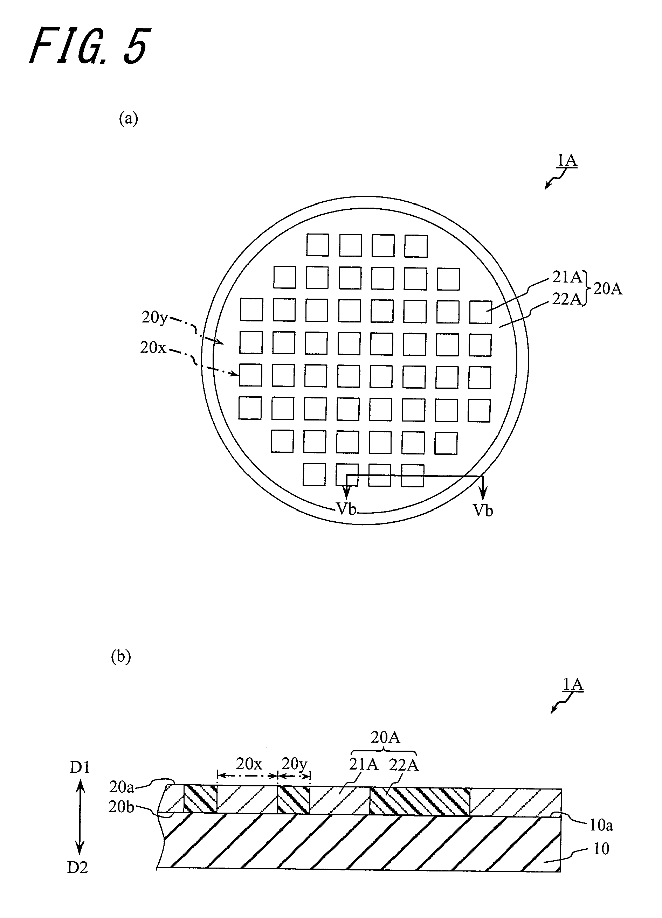

A composite substrate 1A shown in Fig. 5 is different from the composite substrate 1 in that the composite substrate 1A includes a semiconductor substrate 20A. An oxidized portion 22A of the semiconductor substrate 20A faces a top main surface 20Aa and a bottom main surface 20Ab of the semiconductor substrate 20A. That is, since the oxidized portion 22A penetrates the semiconductor substrate 20A in the D1-D2 direction, even when a plurality of element portions are formed on one semiconductor device 2, isolation between the element portions can be further increased.

### <Third Embodiment of Composite Substrate>

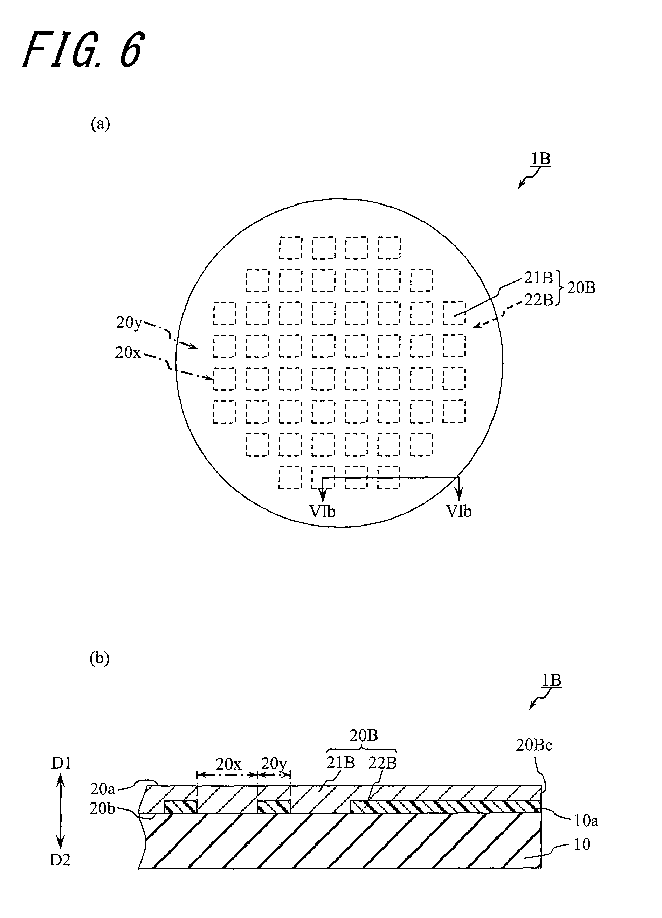

A composite substrate 1B shown in Fig. 6 is different from the composite substrate 1 in that the composite substrate 1B includes a semiconductor substrate 20B. The oxidized portion 22B of the semiconductor substrate 20B is exposed from a side surface 20Bc of the semiconductor substrate 20B. That is, a main portion 21C and the oxidized portion 22B face the side surface 20Bc of the semiconductor substrate 20B. In addition, the semiconductor substrate 20B faces a bottom main surface 20Bb and the side surface 20Bc of the semiconductor substrate 20B. In the composite substrate 1B, in various steps at the time of manufacturing the semiconductor device, the peeling off of the semiconductor substrate 20B from the circumference can be reduced.

Moreover, in the present embodiment, the oxidized portion 22B is formed from the first region 20x to the circumference of the semiconductor substrate 20B. The bonding area between the support substrate 10 and the semiconductor substrate 20B is increased, and thus, the bonding can be favorably performed.

Moreover, the oxidized portion 22B of the semiconductor substrate 20B may penetrate in the D1-D2 direction like the oxidized portion 22A of the semiconductor substrate 20A.

### <Fourth Embodiment of Composite Substrate>

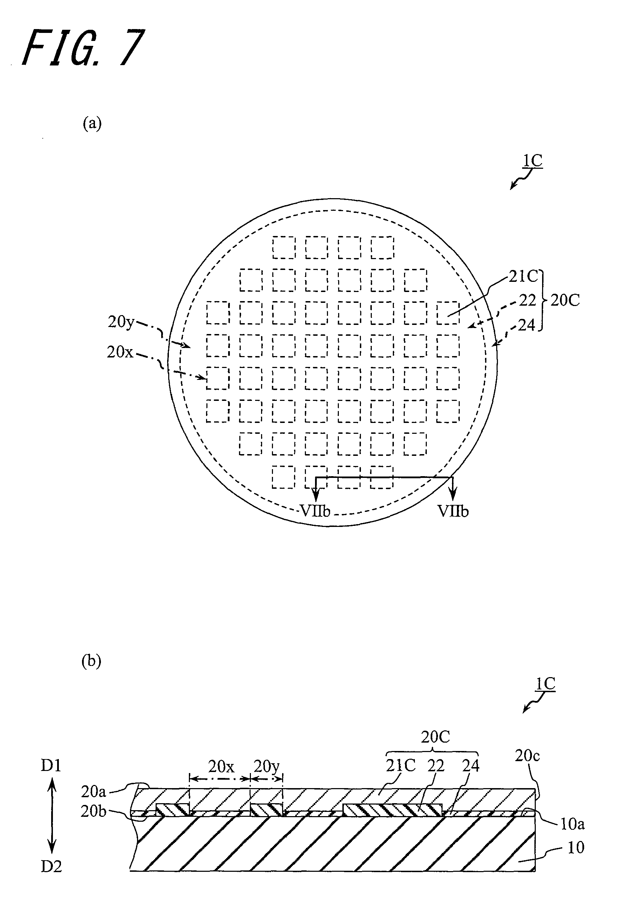

A composite substrate 1C shown in Fig. 7 is different from the composite substrate 1 in that the composite substrate 1C includes a semiconductor substrate 20C. The semiconductor substrate 20C includes a main portion 21C, an oxidized portion 22, and a second oxidized portion 24. The second oxidized portion 24 faces the bottom main surface 20b of the semiconductor substrate 20C and is disposed between the support substrate 10 and the main portion 21C. The thickness of the second oxidized portion 24 along the D1-D2 direction is thinner than the thickness of the oxidized portion 22. It is preferable that the second oxidized portion 24 is formed so as to be thin using natural oxidation. From the viewpoint of heat dissipation, it is preferable that the second oxidized portion 24 is significantly thin.

By providing the second oxidized portion 24, in the composite substrate 1C, adhesiveness between the support substrate 10 and the semiconductor substrate 20C is further increased. Moreover, since the thickness of the second oxidized portion 24 is thinner than the thickness of the oxidized portion 22, in the composite substrate 1C, a decrease of the heat dissipation of the first region 20x can be suppressed. That is, in the composite substrate 1C, compatibility between adhesiveness thereof to the support substrate 10 and heat dissipation of the support substrate 10 is improved.

The thickness of the second oxidized portion 24 is not particularly limited as long as the thickness is in such a range that it does not exceed the thickness of the oxidized portion 22. For example, the thickness of the oxidized portion 22 may be 100 nm, and the thickness of the second oxidized portion 24 may be 2 nm or less.

In addition, like the oxidized portion 22A of the semiconductor substrate 20A, the oxidized portion 22C of the semiconductor substrate 20C may penetrate in the D1-D2 direction.

### <Second Embodiment of Method for Manufacturing Composite Substrate>

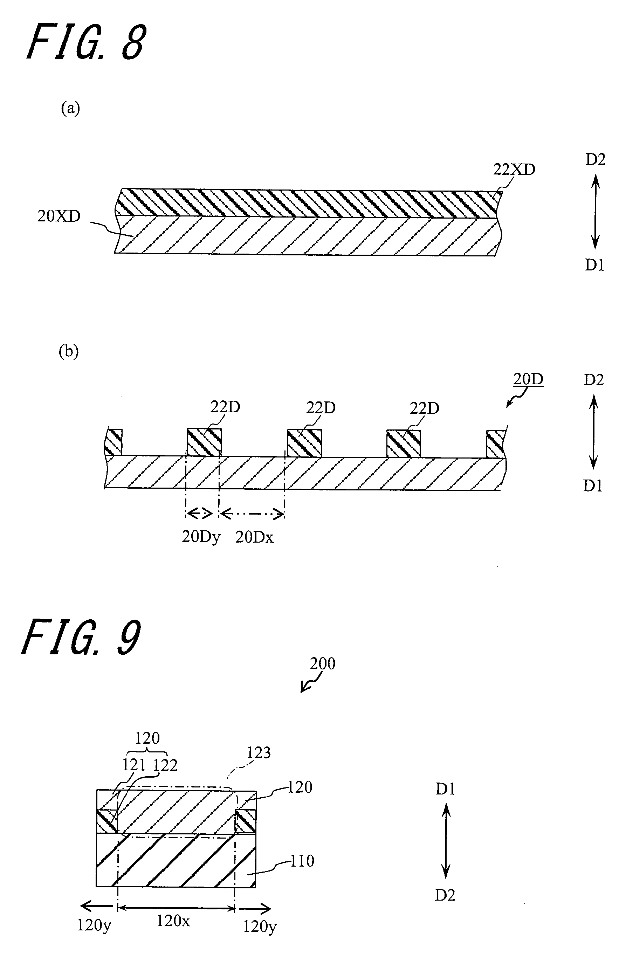

In the manufacturing method of the composite substrate shown in Figs. 2 and 3, the oxidized portion forming step may be a step shown in Fig. 8.

Specifically, as shown in Fig. 8(a), an oxidized layer 22XD is formed on a semiconductor substrate 20XD. The oxidized layer 22XD may be formed by oxidizing the surface of the semiconductor substrate 20XD using thermal oxidation and may be formed using a thin layer forming method.

Subsequently, as shown in Fig. 8(b), a portion of the oxidized layer 22XD is removed, the oxidized layer 22XD becomes a partial oxidized layer 22YD, and thus, a semiconductor substrate 20D is obtained. The partial oxidized layer 22YD becomes an oxidized portion 22D. The region in which the surface of the semiconductor substrate 20D is exposed from the oxidized portion 22D becomes a first region 20Dx, and the region excluding the first region 20XD becomes a second region 22Dy which includes the oxidized portion 22D on one surface.

### <Embodiment of Electronic Component>

An example of an embodiment of an electronic component of the invention will be described with reference to Fig. 9. An electronic component 200 shown in Fig. 9 includes a support chip 110 having electric insulating properties and a silicon chip 120 disposed on the support chip 110. For example, the support chip 110 is formed of sapphire. The silicon chip 120 includes a first region 120x on which an element portion 123 which functions as a semiconductor device is formed, and a second region 120y which is provided surrounding the first region 120x in a plan view. An oxidized portion 122 which contains silicon oxide as a main component is disposed in the main surface of the second region 120y closer to the support chip 110 side.

Since the element portion 123 and the support chip 110 are directly bonded to each other, the electronic component 200 can be provided in which parasitic capacitance is small, heat generated in the element portion 123 can be dissipated to the support chip 110 side, and heat dissipation is improved.

Moreover, since the support chip 110 and the silicon chip 120 are securely connected to each other due to the oxidized portion 122 of the second region 120y, the electronic component 200 can be provided in which separation of both chips can be suppressed and reliability is high.

In addition, in the electronic component 200 shown in Fig. 9, the entire outer circumferential side surface of the silicon chip 120 is covered by the second region 120y. In other words, the oxidized portion 122 is exposed to the outer circumferential surface of the silicon chip 120. According to this configuration, the electronic component 200 can be provided in which the peeling from the circumferential portion of the side surface is suppressed and reliability is high.

For example, the electronic component 200 shown in Fig. 9 can be manufactured through the steps shown in Fig. 4. That is, the support chip 110 and the silicon chip 120 are formed by dividing the support substrate 10 and the semiconductor substrate 20, respectively, in the composite substrate 1.

### <Modified Example of Electronic Component>

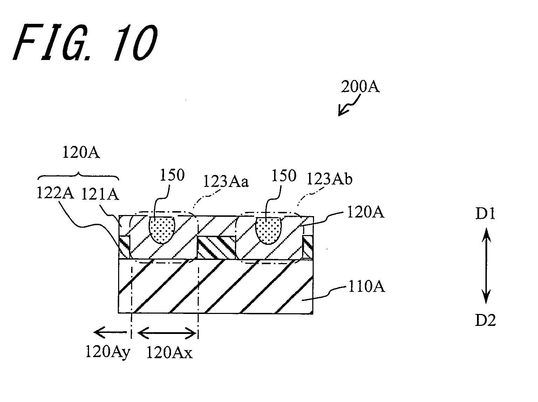

The electronic component 200 shown in Fig. 9 is the configuration which includes one element portion 123 in one electronic component. However, like an electronic component 200A shown in Fig. 10, the electronic component may include a plurality of element portions 123Aa and 123Ab in one electronic component.

Here, the electronic component 200A includes impurity diffusion regions 150 in which impurities are doped in the depth direction (thickness direction) from the surfaces of first regions 120Aa and 120Ab in element portions 123Aa and 123Ab. Moreover, total thickness in which the thickness of the impurity diffusion region 150 and the thickness of the oxidized portion 122A are summed up is thicker than the thickness of the silicon chip 120A. In other words, the region in which the impurity diffusion region 150 is present and the region in which the oxidized portion 122A is present are overlapped in the depth direction. According to this configuration, mixing of unintended noise between the element portions 123Aa and 123Ab can be suppressed. Here, the thickness of the impurity diffusion region 150 is simply referred to as the thickness of the element portion. Moreover, the thickness of the impurity diffusion region 150 means the distance from the top surface of the silicon chip 120 to the most distant position in the depth direction in the impurity diffusion region 150.

In addition, in this example, the oxidized portion 122A face only the main surface (bottom surface) 120Aa of the silicon chip 120A closer to the support chip 110 side. However, the oxidized portion 122A may face both the bottom surface 120Aa and the top surface 120Ab of the silicon chip 120A. In other words, the oxidized portion 122A may penetrate the silicon chip 120 in the D1-D2 direction.

In addition, the invention is not limited to the above-described embodiments, and various changes may be performed within a scope which does not depart from the gist of the invention.

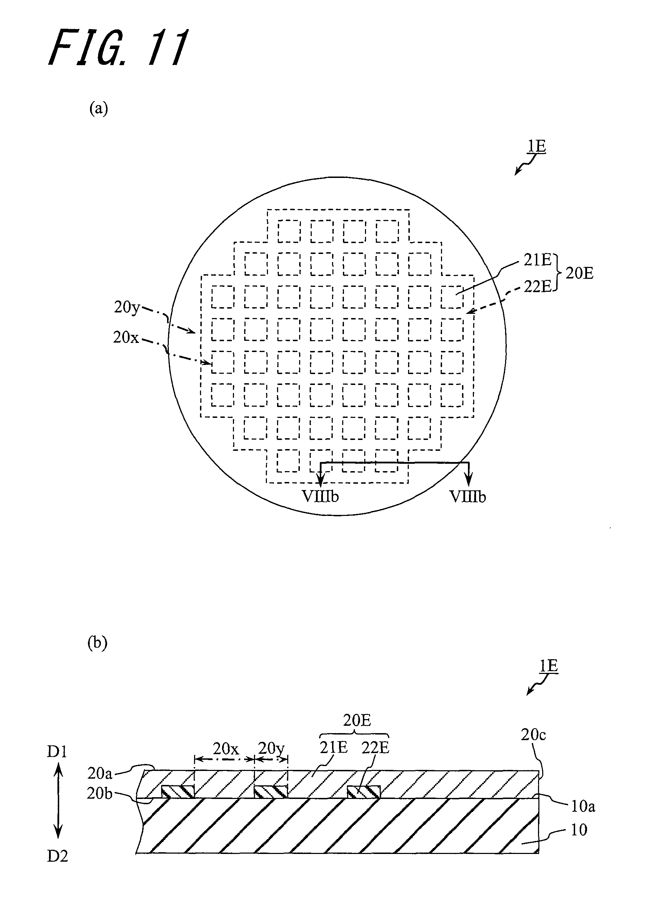

For example, in the semiconductor substrate 20, the oxidized portion 22 is formed from the circumference of the first region 20x to the circumference of the main portion 21. However, the invention is not limited thereto. For example, like a semiconductor substrate 20E shown in Fig. 11, a configuration in which an oxidized portion 22E surrounds the circumference of the first region 20x may be provided.

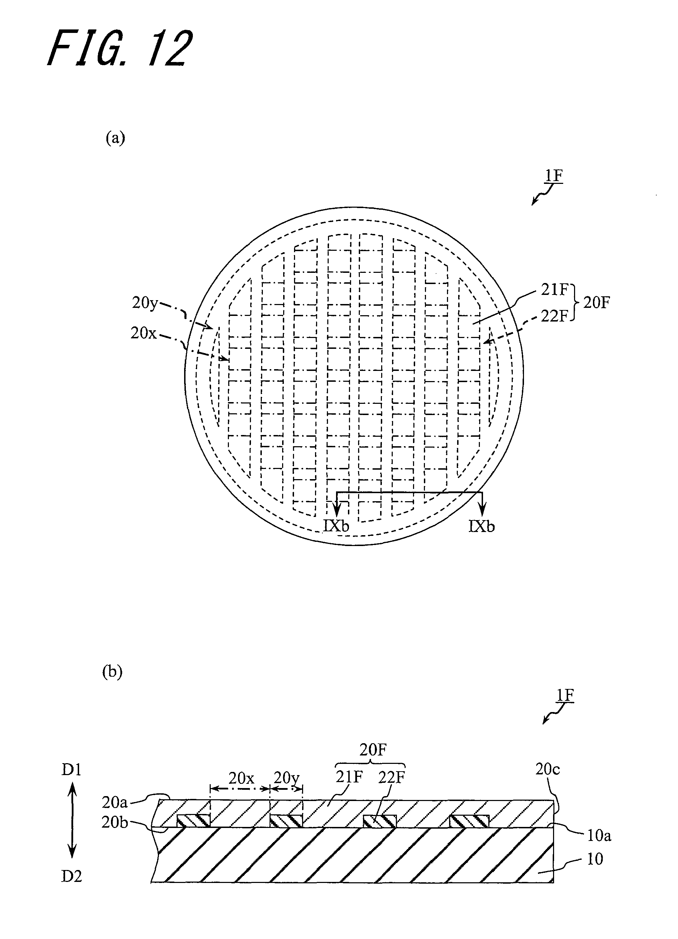

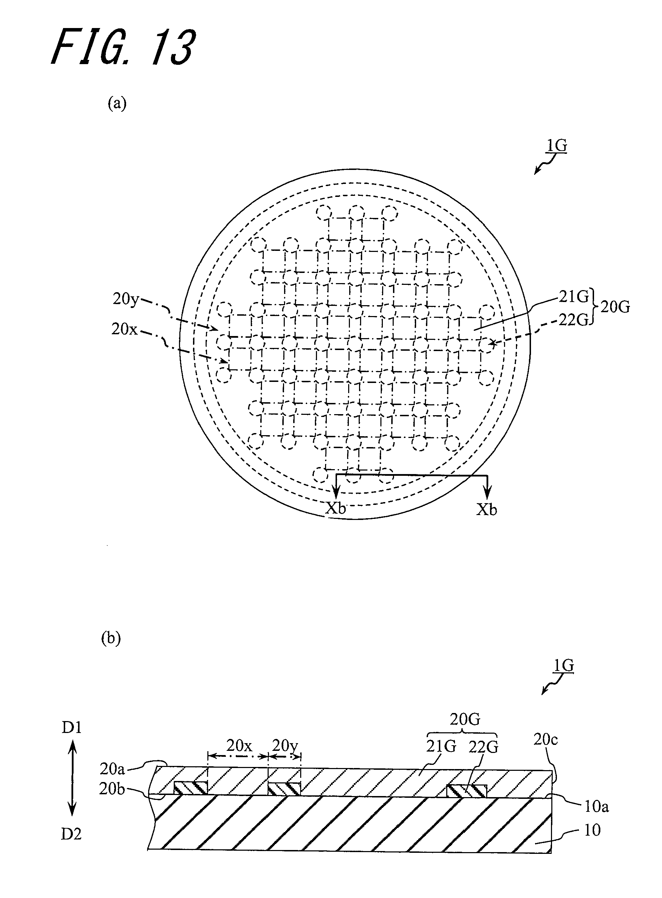

Moreover, in the semiconductor substrate 20, the oxidized portion 22 surrounds the first region 20x in a grid pattern. However, the invention is not limited to the shape. For example, like the semiconductor substrate 20F shown in Fig. 12, a pair of oxidized portions 22F may extend along the first region 20x. In addition, like a semiconductor substrate 20G shown in Fig. 13, oxidized portions 22G may be provided on four corners of the first region 20x.

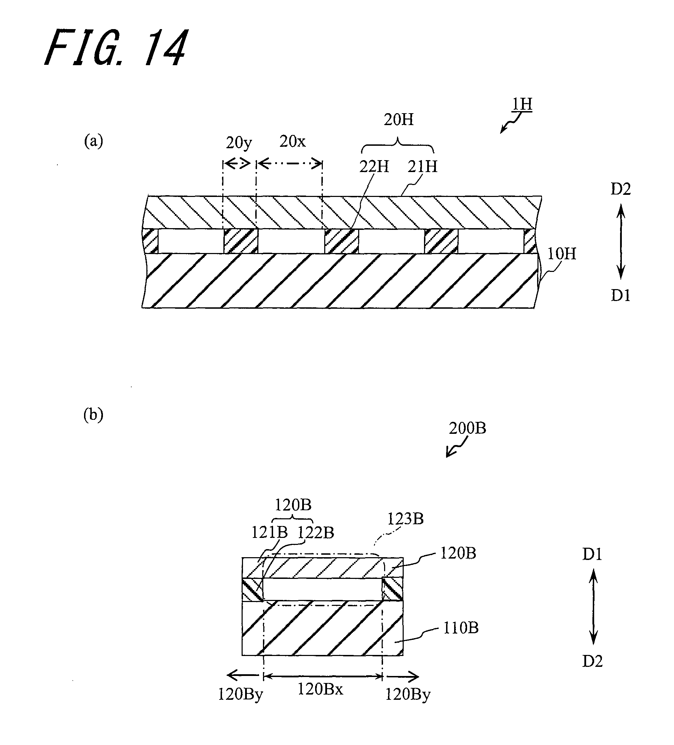

Moreover, in the semiconductor substrate 20, the surfaces of the oxidized portions 22 of the first region 20x and the second region 20y are in the same plane. However, a step shown in Fig. 14(a) may be provided if the oxidized portion 22 is securely connected to the support substrate 10. Moreover, the electronic component 200 may be an electronic component 200B as shown in Fig. 14(b). For example, the electronic component 200B can be obtained by dividing a composite substrate 1H.

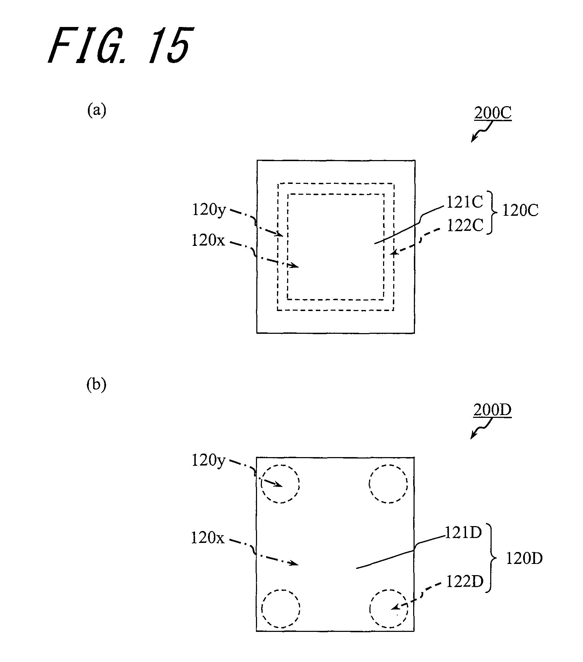

In addition, in the electronic component 200, the second region 120y is exposed to the outer circumferential side surface of the electronic component 200. However, like an electronic component 200C shown in Fig. 15(a), the second region 120y may not be exposed to the outer circumferential side surface of the electronic component 200C. In other words, in the electronic component 200C, the second region 120y is disposed inside the outer circumferential portion in a plan view. It may be said that the first region 120x is exposed to the entire outer circumferential side surface.

Moreover, in the electronic component 200, the second region 120y is formed so as to be continuous to surround the entire circumference of the first region. However, the second region 120y may be discontinuous, like an electronic component 200D shown in Fig. 15(b), the first region may be disposed surrounding the plurality of second regions 120y. For example, the electronic component 200D can be obtained by dividing the composite substrate 1G shown in Fig. 13.

Moreover, in the specification and in the modified examples of each component, capital letters such as A to F are added to the final position of the reference numerals of the components before modification.

### Reference Signs List

1, 1A, 1B, 1C: Composite substrate
2: Semiconductor device
10: Support substrate
10a: Top surface
20, 20A, 20B, 20C, 20D, 20E, 20F: Semiconductor substrate
20a: Top main surface
20b: Bottom main surface
20c: Side surface
21, 21A, 21B, 21C, 21D, 21E, 21F: Main portion
22, 22A, 22B, 22C, 22D, 22E, 22F: Oxidized portion
23: Element portion
24: Second oxidized portion
20x: First region
20y: Second region
20X: Substrate material
21X: Unoxidized portion
22X, 22Y, 22Z: Oxidized layer

## Claims

1. A composite substrate, comprising:
a support substrate having electric insulating properties; and
a silicon substrate disposed on the support substrate, the silicon substrate comprising a plurality of first regions and a second region positioned between the plurality of first regions,
an oxidized portion containing silicon oxide as a main component, the oxidized portion being disposed on a main surface of the second region closer to the support substrate side.

2. The composite substrate according to claim 1,
wherein the support substrate is a single crystal containing aluminum oxide as a main component.

3. The composite substrate according to claim 1 or 2,
wherein the oxidized portion surrounds circumference of the plurality of first regions.

4. The composite substrate according to any one of claims 1 to 3,
wherein the oxidized portion penetrates the silicon substrate in a thickness direction thereof.

5. The composite substrate according to any one of claims 1 to 4,
wherein the oxidized portion is exposed from a side surface of the silicon substrate.

6. The composite substrate according to any one of claims 1 to 3,
wherein the oxidized portion is positioned inside other surfaces excluding a main surface of the silicon substrate closer to the support substrate side.

7. The composite substrate according to any one of claims 1 to 6,
wherein second oxidized portions which are thinner than the oxidized portion are positioned on the main surfaces of the plurality of first regions closer to the support substrate side.

8. The composite substrate according to any one of claims 1 to 7,
wherein bonding strength between the second region and the support substrate is larger than bonding strength between the plurality of first regions and the support substrate.

9. A method for manufacturing a composite substrate, comprising:
an oxidized portion forming step of providing an oxidized portion containing silicon oxide as a main component, on a surface of a second region in a silicon substrate comprising a plurality of first regions and the second region positioned between the plurality of first regions; and
a bonding step of bonding the oxidized portion of the silicon substrate to a support substrate having electric insulating properties.

10. The method for manufacturing a composite substrate according to claim 9,
wherein the oxidized portion is formed by oxidizing the surface of the second region in the silicon substrate in the oxidized portion forming step.

11. The method for manufacturing a composite substrate according to claim 9,
wherein the oxidized portion forming step comprises:
a step of forming an oxidized layer containing silicon oxide as a main component on the silicon substrate, and
a step of forming the plurality of first regions exposed from the oxidized layer and a second region which comprises the oxidized portion formed by removing a portion of the oxidized layer on the surface, on the silicon substrate.

12. The method for manufacturing a composite substrate according to claim 9,
wherein the oxidized portion forming step includes:
a step of forming a first oxidized layer which covers the plurality of first regions on the silicon substrate, leaving the second region exposed,
a step of oxidizing surfaces of the plurality of first regions covered with the first oxidized layer and the surface of the second region which is not covered with the first oxidized layer, remaining unoxidized portions as they are, and of forming a second oxidized layer which covers the plurality of first regions and the second region in which the first oxidized layer and newly oxidized region are combined, and
a step of etching the second oxidized layer up to surfaces of the unoxidized portions of the plurality of first regions which are exposed and of preparing the oxidized portion composed of an exposed remaining portion of the second oxidized layer.

13. The method for manufacturing a composite substrate according to any one of claims 9 to 12,
wherein second oxidized portions, which are thinner than the oxidized portion, are formed on surfaces of the plurality of first regions in the silicon substrate using natural oxidation.

14. A method for manufacturing an electronic component, further comprising:
a step of forming a plurality of element portions which function as a semiconductor device corresponding to the plurality of first regions in the composite substrate according to any one of claims 1 to 8; and
a step of dividing the composite substrate into regions each of which includes at least one of the plurality of element portions.

15. The method for manufacturing an electronic component according to claim 14,
wherein the composite substrate is divided in such a manner that the second region is exposed in divided surfaces formed by dividing the composite substrate in the step of dividing the composite substrate.

16. An electronic component, comprising:
a support chip having electric insulating properties; and
a silicon chip disposed on the support chip, wherein
the silicon chip comprises a first region on which an element portion which functions as a semiconductor device is formed, and a second region which is disposed surrounding the first region,
an oxidized portion containing silicon oxide as a main component which is disposed on a main surface of the second region closer to the support chip side.

17. The electronic component according to claim 16,
wherein the second region covers an entire outer circumferential side surface of the silicon chip.

18. The electronic component according to claim 16 or 17,
wherein a total of thicknesses of the oxidized portion and the element portion is larger than a thickness of the silicon chip.
